# EUROPEAN PATENT SPECIFICATION

(11) **EP 2 668 717 B1**
(45) Date of publication and mention of the grant of the patent: **22.05.2019**
(21) Application number: 11784576.8
(22) Date of filing: 03.08.2011
(51) Int. Cl.: H02S 99/00, H01Q 1/24, H01Q 1/44

(54) **PHOTOVOLTAIC ELEMENT WITH A RESONATOR WITH ELECTROMAGNETIC DAMPING**
PHOTOVOLTAIKELEMENT MIT EINEM RESONATOR MIT ELEKTROMAGNETISCHER DÄMPFUNG
ÉLÉMENT PHOTOVOLTAÏQUE AVEC UN RÉSONATEUR AVEC AMORTISSEMENT ÉLECTROMAGNÉTIQUE

(30) Priority: 27.01.2011 CZ 20110042
(43) Date of publication of application: 04.12.2013
(73) Proprietor: Vysoké ucení Technické v Brne, 601 90 Brno (CZ)
(72) Inventor: PAVEL, Fiala, 61400 Brno (CZ)
(74) Representative: Kendereski, Dusan
(86) International application number: PCT/CZ2011/000076
(87) International publication number: WO 2012/100758

(56) References cited:
- WO-A1-2009/064736
- FIALA P ET AL: "Tuned Structures for Special THz Applications", PIERS PROCEEDINGS, BEIJING, CHINA, MARCH 23-27, 2009, 2009, pages 151-155, XP55023499,
- FIALA P ET AL: "Tuned Periodical Structures - Model, Experiments in THz Band Applied in Safety Application", PIERS PROCEEDINGS, CAMBRIDGE, USA, JULY 5-8, 2010, 2010, pages 1022-1026, XP55023502,
- KOTTER D K ET AL: "Theory and Manufacturing Processes of Solar Nanoantenna Electromagnetic Collectors", JOURNAL OF SOLAR ENERGY ENGINEERING, ASME INTERNATIONAL, US, vol. 132, no. 1, February 2010 (2010-02), pages 11014-1-11014-9, XP009157838, ISSN: 0199-6231, DOI: 10.1115/1.4000577
- CORKISH R ET AL: "Efficiency of antenna solar collection", PROCEEDINGS OF THE 3RD WORLD CONFERENCE ON PHOTOVOLTAIC ENERGY CONVERSION : JOINT CONFERENCE OF 13TH PV SCIENCE & ENGINEERING CONFERENCE, 30TH IEEE PV SPECIALISTS CONFERENCE, 18TH EUROPEAN PV SOLAR ENERGY CONFERENCE; OSAKA INTERNATIONAL CONGRESS CENT, vol. 3, 18 May 2003 (2003-05-18), pages 2682-2685, XP031987880, ISBN: 978-4-9901816-0-4
- OSGOOD R M III ET AL: "Nanoantenna-coupled MIM nanodiodes for efficient vis/nir energy conversion", PROCEEDINGS OF SPIE, vol. 6652, 2007, pages 665203-1-665203-11, XP55023485, ISSN: 0277-786X, DOI: 10.1117/12.733168
- FIALA P J: "Novel vibrational and solar energy harvesters", SPIE NEWSROOM, 27 July 2011 (2011-07-27), XP55023488, DOI: 10.1117/2.1201105.003669
- FIALA P ET AL: "Energy harvesting circuit for sensor system power supply", PROCEEDINGS OF SPIE, vol. 8066, 5 May 2011 (2011-05-05), pages 80661B-1-80661B-13, XP55023491, ISSN: 0277-786X, DOI: 10.1117/12.884768
- CLOETE J H ET AL: "Ridged cavity backed slot antenna with dielectric loading", ELECTRONICS LETTERS, vol. 25, no. 5, 2 March 1989 (1989-03-02), pages 323-324, XP55023483, ISSN: 0013-5194, DOI: 10.1049/el:19890224
- YANG R ET AL: "Bandwidth enhancement of microstrip antennas with metamaterial bilayered substrates", JOURNAL OF ELECTROMAGNETIC WAVES AND APPLICATIONS, vol. 21, no. 15, 2007, pages 2321-2330, XP009158033, ISSN: 0920-5071, DOI: 10.1163/156939307783134425

## Description

### Technical Field of the Invention

The invention relates to a photovoltaic element including a resonator and characterized by a high rate of efficiency related to the transformation of the energy of light to electric energy, the element comprising a semiconductor structure located between two electrodes.

### State of the Art

In contemporary photovoltaics, more than fifty-year-old principles of transforming solar electromagnetic radiation (wideband electromagnetic radiation within the wavelength range of 100 nm to 10000 nm) are generally applied. The solar cells are composed of two semiconductor layers (with silicon being the usual material) located between two metal electrodes. One of the layers (an N-type material) comprises a multitude of negatively charged electrons, whereas the other layer (a P-type material) shows a large number of "holes" definable as void spaces that easily accept electrons. Devices transforming electromagnetic waves to a lower-frequency electromagnetic wave, or a direct component, are known as transvertors/converters. For this purpose, semiconductor structures with differing concepts and types of architecture are applied, respecting only experimental results of the electromagnetic wave transformation effect.
The antennas, detectors, or structures designed to date are not tuned into resonance; the applied semiconductor structures face considerable difficulty in dealing with emerging stationary electromagnetic waves.

Similar solutions utilize the principles of antennas as well as the transformation of a progressive electromagnetic wave to another type of electromagnetic radiation (namely a progressive electromagnetic wave having different polarization or a stationary electromagnetic wave) and its subsequent processing. Certain problems occur in connection with the impinging electromagnetic wave and its reflection as well as in relation to the wide-spectrum character of solar radiation. In general, it is not easy to construct an antenna capable of maintaining the designed characteristics in the wide spectrum for the period of several decades.

Document WO 2009/064736A1 discloses methods, devices and systems for harvesting energy from electromagnetic radiation including harvesting energy from electromagnetic radiation. In one embodiment, a device includes a substrate and one or more resonance elements disposed in or on the substrate. The resonance elements are configured to have a resonant frequency, for example, in at least one of the infrared, near infrared and visible light spectra. A layer of conductive material may be disposed over a portion of the substrate to form a ground plane. An optical resonance gap or stand-off layer may be formed between the resonance elements and the grand plane. The optical resonance gap extends a distance between the resonance elements and the layer of conductive material approximately one-quarter wavelength of a wavelength of the at least one resonance element's resonant frequency. At least one energy transfer element may be associated with the at least one resonance element.

In P. Fiala et al.: "Tuned Structures for Special THz Applications", PIERS PROCEEDINGS, BEIJING, CHINA, March 23-27, 2009, pp. 151-155, particulars of new research in the special structures used for THz applications are presented. The practical application is focused on impedance matching of the basic THz structure for the wave transformation. The element produced by nanotechnology was numerically modelled and the analysis of obtained results was used for the subsequent chase of design. The final design was prepared for the mid-infrared and long-infrared wavelength applications. According to the interpretation of the results, the basic design was prepared for experimental fabrication of the first prototype of these nanostructure elements.

In P. Fiala et al.: "Tuned Periodical Structures - Model, Experiments in THz Band Applied in Safety Application", PIERS PROCEEDINGS, CAMBRIDGE, USA, July 5-8, 2010, pp. 1022-1026, experiments using an algorithm set up for the refraction and reflection of electromagnetic wave on the interface with the help of the refraction coefficient and the permeance coefficient are described. The procedure is adjusted for a multilayer heterogeneous material (layers, metamaterials). A resonant circuit basis element is prepared and tested on frequency spectrum <400 nm, 700 nm>.

In D.K. Kotter et al.: "Theory and Manufacturing Processes of Solar Nanoantenna Electromagnetic Collectors", JOURNAL OF SOLAR ENERGY ENGINEERING, VOL. 132, NO. 1, FEBRUARY 2010, pp. 011014-1 - 011014-9, a research exploring a new and efficient approach for producing electricity from the abundant energy of the sun, using nanoantenna (nantenna) electromagnetic collectors (NECs) is described. NEC devices target midinfrared wavelengths, where conventional photovoltaic (PV) solar cells are inefficient and where there is an abundance of solar energy. The initial concept of designing NECs was based on scaling of radio frequency antenna theory to the infrared and visible regions. This approach initially proved unsuccessful because the optical behavior of materials in the terahertz (THz) region was overlooked and, in addition, economical nanofabrication methods were not previously available to produce the optical antenna elements. This paper demonstrates progress in addressing significant technological barriers including: (1) development of frequency-dependent modeling of double-feedpoint square spiral nantenna elements, (2) selection of materials with proper THz properties, and (3) development of novel manufacturing methods that could potentially enable economical large-scale manufacturing. It has been shown that nantennas can collect infrared energy and induce THz currents and cost-effective proof-of-concept fabrication techniques for the large-scale manufacture of simple square-loop nantenna have been developed. This work represents an important first step toward the ultimate realization of a low-cost device that will collect as well as convert this radiation into electricity. This could lead to a broadband, high conversion efficiency low-cost solution to complement conventional PV devices. Further work has been planned to embed rectifiers into the double-feedpoint antenna structures.

### Summary of the Invention

The invention is aimed to propose a new architecture of a photovoltaic element having a resonator arranged on a semiconductor structure. Based on the utilized construction technique, the element resonates and produces high-value components of the electric and magnetic fields in such a manner that these components are utilizable and processible by means of the well-known technology based on classical semiconductors.

The above-mentioned drawbacks are eliminated by a photovoltaic element as claimed in independent claim 1.

The creation of high-value components of the electric and magnetic fields can be realized conveniently when the 2D-3D resonator is composed of two parts as described in claim 1, wherein the reflector is arranged as claimed in dependent claim 2.

The invention utilizes the spectrum of solar radiation in which the electromagnetic wave power flow density (W/m²) is high. Within the presented invention, the photovoltaic element in the form of a resonator arranged on a semiconductor structure is characterised by a high rate of efficiency related to the transformation of the energy of light to electric energy.

The main advantage of the newly constructed photovoltaic element with semiconductor structure consists in the manner of its composition, namely in the planar and spatial resonator (2D-3D resonator), which is part of the semiconductor structure. This structure does not generate a backward electromagnetic wave propagating in the direction of the impinging electromagnetic wave emitted by a source such as the Sun. The 2D-3D resonator is designed in such a manner that prevents the electromagnetic wave passing through the semiconductor structure from being reflected back to the 2D-3D resonator created in the structure. Thus, the resonator behaves like an ideal impedance-matched component for the proposed frequency spectrum.

The semiconductor structure on which the 2D-3D resonator is arranged consists of two parts, namely a region without electromagnetic damping and a region with electromagnetic damping, which are bounded by the planes of variation in material properties, wherein the region with electromagnetic damping has the function of suppressing the reflected wave. At least one 2D-3D resonator is arranged on the incidence plane which, in this case, is identical with the plane of variation in material properties. These parts ensure optimal processing of the electromagnetic wave; the processing is realized in such a way that the occurence of a reflected wave towards the 2D-3D resonator is prevented. Behind the region with electromagnetic damping, which ends at the plane of variation in material properties, there follows the arranged reference electrode.

Importantly, the photovoltaic element having a resonator arranged on a semiconductor structure does not utilize the structure and its characteristics to secure the generation of an electric charge, but rather uses both these aspects to set suitable conditions for the impingement of an electromagnetic wave and its transformation to a stationary form of electromagnetic field.

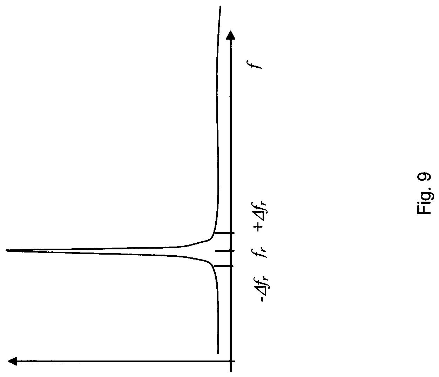

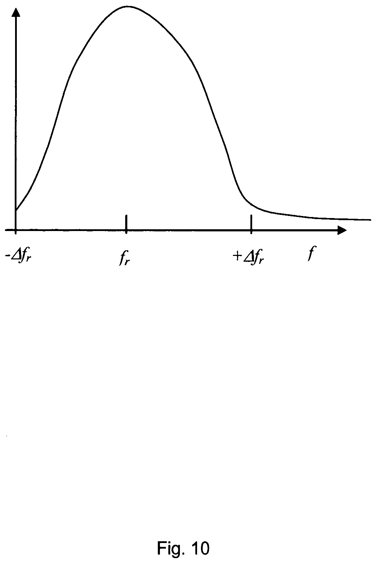

Another advantage consists in the fact that the doping material will induce an increase in gamma conductivity [S/m] in the semiconductor structure material. This structure is set in order for the conductivity to increase, in the region with electromagnetic damping, in the direction of the reference electrode. Thus, the photovoltaic element components arranged on the semiconductive structure behave in such a way that they create a wide resonance curve (Fig. 10). This enables us - in comparison with cases when the semiconducting material is not modified as described above, Fig. 9 - to comprise the desired frequency spectrum of the impinging electromagnetic wave using a markedly lower number of variants of tuned semiconducting structures within the complex of the designed structure.

Based on the presented invention, the described solution allows the adaptation of invididual photovoltaic elements in the resulting structure to density conditions of the impinging electromagnetic radiation as present at the location where the elements are applied. In consequence of this characteristic, it is possible for us to utilize (harvest) the maximum energy of the incident electromagnetic radiation and to profit from the change of the radiation to the required form of energy that provides for further application (for example, as an electric energy source or generator). The designed photovoltaic elements including resonators are imbedded in panels which, when interconnected, form photovoltaic fields.

### Brief Description of the Drawings

The principle of the invention will be clarified through the use of drawings, where Fig. 1 describes the basic configuration of a photovoltaic element with a 2D-3D resonator, Fig. 2 illustrates the exemplary embodiment of a photovoltaic element including a system of 2D-3D resonators and connecting components arranged on a semiconductor structure, Fig. 3 shows a schematic view of a 2D-3D resonator arranged on a semiconductor structure, Fig. 4 represents the configuration of a 2D-3D resonator and reflector, Fig. 5 describes the partial spatial arrangement of a 2D-3D resonator in the dielectric and reflector region within the semiconductor structure of a photovoltaic element, Fig. 6a illustrates the axonometric view of a resonator (formed by a reflector) above which the dielectric and the transformation component are arranged, Fig. 6b shows a lateral view of a resonator, Fig. 7a represents the connection of a transformation component with a nonlinear component in the forward direction, Fig. 7b describes the connection of a transformation component with a nonlinear component in the backward direction, Fig. 8 shows the resonant circuit connection (the circuit consists of a photovoltaic element and related electronics), Fig. 9 illustrates the resonance curve of a classic resonator, and Fig. 10 provides the resonance curve of the proposed resonator.

### Exemplary Embodiment of the Invention

The principle of constructing a photovoltaic element with a resonator arranged on a semiconductor structure will be clarified by but not limited to the examples provided below.

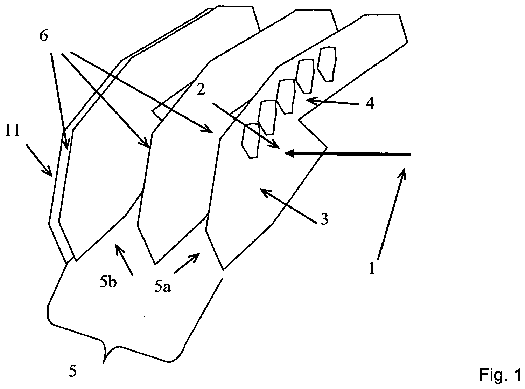

The essential embodiment of a 2D-3D resonator arranged on a semiconductor structure is provided in Fig. 1. This form of a photovoltaic element includes a semiconductor structure **5,** which consists of two parts. These two parts constitute the region **5a** without electromagnetic damping and the region **5b** with electromagnetic damping, both of which are bounded by virtual (assumed) boundaries **6** of variation in material properties. Furthermore, the semiconductor structure **5** includes at least one 2D-3D resonator **4** arranged on the incidence plane **3,** which, in this case, is identical with the boundary **6** of variation in material properties. After the region **5b** with electromagnetic damping, which is bounded from both sides by the boundary **6** of variation in material properties, there follows the arranged reference electrode **11.**

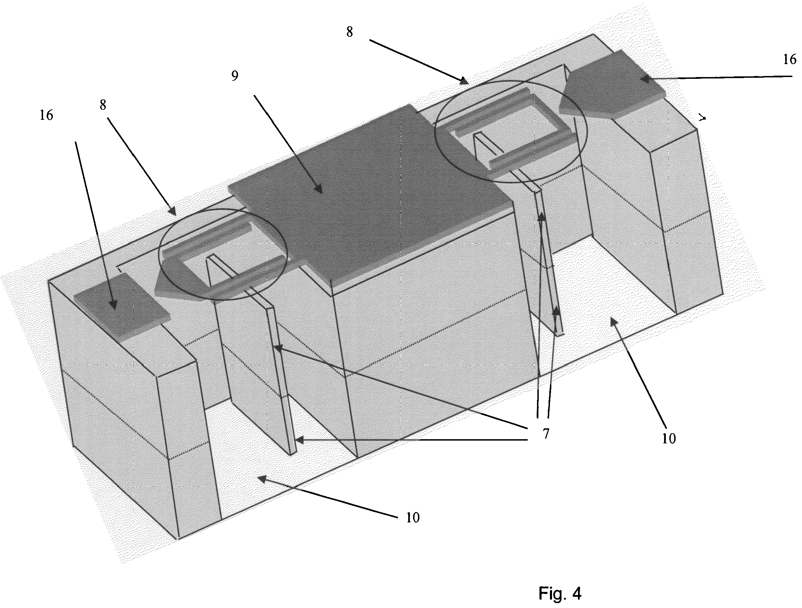

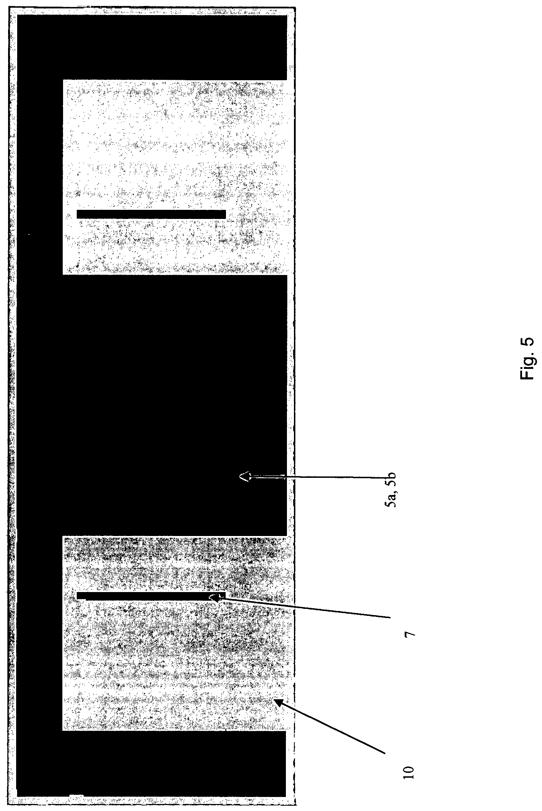

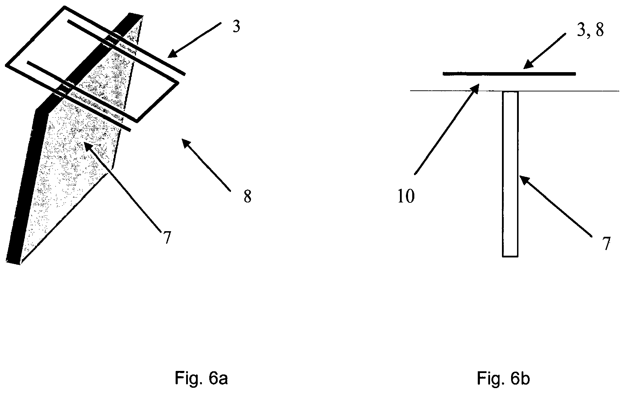

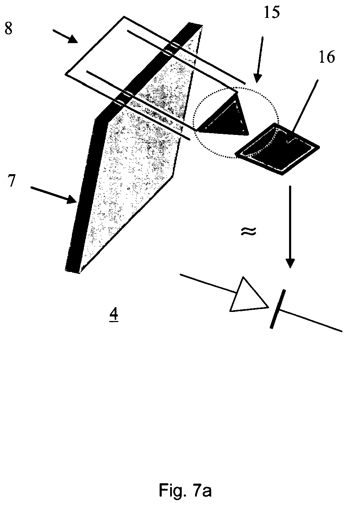

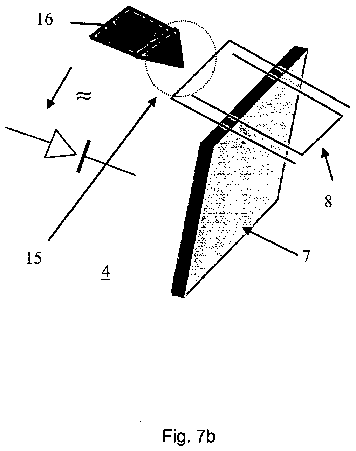

The 2D-3D resonator **4** is described in Fig. 4, Fig. 6a and Fig. 6b. This embodiment of the 2D-3D resonator **4** consists of a transformation component **8** and a reflector **7,** between which the dielectric **10** (such as an insulant) is arranged, with the transformation component **8** constituted by a pair of electrodes in the form of coupled conductors surrounded by the dielectric **10.** Furthermore, the transformation component **8** is arranged on the dielectric **10,** upon which the reflector **7** is placed orthogonally. Fig. 5 shows the arrangement of the dielectric **10** in the semiconductor structure. The 2D-3D resonator **4** produces electric current or voltage, which is conducted by the help of a nonlinear component **15** to the connecting component **16;** this situation can be seen in Figs. 7a and 7b, where both types of the nonlinear component **15** polarization are described.

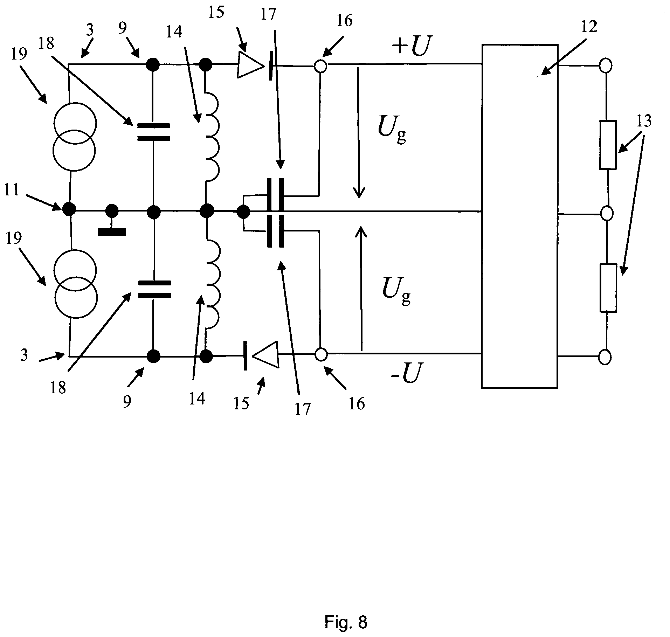

Fig. 8 represents an electrical alternate diagram of the photovoltaic element. The variants concerned are principially a one-way or two-way rectifier, a shaper, or a signal filter. These types of connection are widely known. A source **19** of alternating current or voltages caused by induction from an electromagnetic wave is connected parallelly to the first capacitor **18** and the inductor **14,** which in the connection are constituted by a condenser and a coil. These components then create a tuned alternating circuit (a circuit which is tuned to the characteristics and parameters of the impinging electromagnetic wave and which resonates). The nonlinear element **15** shapes the signal on the resonant circuit; this signal is then filtered (rectified) to a further utilizable shape. As the next step, connection to the second capacitor **17** is realized; in the connection, the capacitor is constituted by a condenser. Also, in the connection, connecting components **16** are indicated. These components **16** show electric voltage +U, -U. If a selected electrical load **13** in the form of impedance *Z* is connected to the connecting components **16** (such as clamps), a variation in the resonant circuit occurs and the resonator may change its characteristics to such an extent that it will not be in a suitable resonance mode. Therefore, a device **12** is introduced before the electrical load **13.** With any loading by electrical impedance *Z* on its output, this device will cause the situation when, on the output, the resonator with the nonlinear component **15** and the second capacitor **17** is loaded by one and the same value of impedance *Z*i, which will not change the set mode of the resonator.

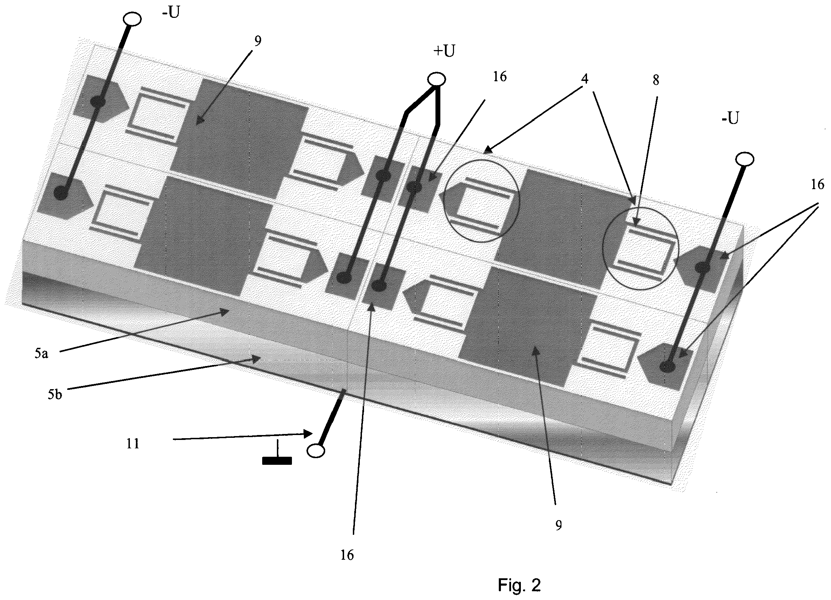

The function (or operation) of the photovoltaic element, which includes a 2D-3D resonator **4** arranged on a semiconductor structure **5,** is as follows: An electromagnetic wave **1** within the wavelength range of 100 nm to 100000 nm impinges at the wave incidence point **2** on the incidence plane **3** of the designed photovoltaic element. The 2D-3D resonator **4** is periodically repeated (as described in Fig. 1 and Fig. 2). In the photovoltaic element incidence plane **3,** the formation of at least one 2D-3D resonator **4** is arranged. This resonator may operate (perform its function) individually; alternatively, we can realize an interconnection between the resonators, thus creating a field of photovoltaic elements. In the incidence plane **3,** these elements are connected parallelly or in series, with the formation of at least two 2D-3D resonators **4** on one photovoltaic element appearing to be an advantageous solution. These resonators are interconnected by means of a connecting element **9.**

An electromagnetic wave **1** impinges at the point of incidence **2** on the incidence plane **3.** Here, the electric and magnetic components of the electromagnetic wave **1** decompose and form the maxima of intensities of the electric and the magnetic fields. This process is realized thanks to the designed shape of the reflector 7, which can be a thin layer, a cuboid, a pyramid, a cone, a toroid, a sphere, or their combination, parts or intersections. The surface of the reflector **7** may be formed by a layer of a dielectric material, metal, or a combination and shape variety of both (the components being part of the 2D-3D resonator **4**)**.** In order for the above-mentioned maxima of intensities to add up arithmetically (superpose) when a connection is realized of two periodically repeated 2D-3D resonators **4**, these resonators are connected by the help of a connecting element **9** (as described in Fig. 2). This figure shows an example of the proposed photovoltaic element having a 2D-3D resonator **4** and arranged on a semiconductor structure **5,** where two 2D-3D resonators **4** are arranged at the location of the incidence plane **3.** These resonators are periodically repeated on other semiconductor structures **5;** also, the 2D-3D resonators **4** are interconnected by means of connecting components **9.**

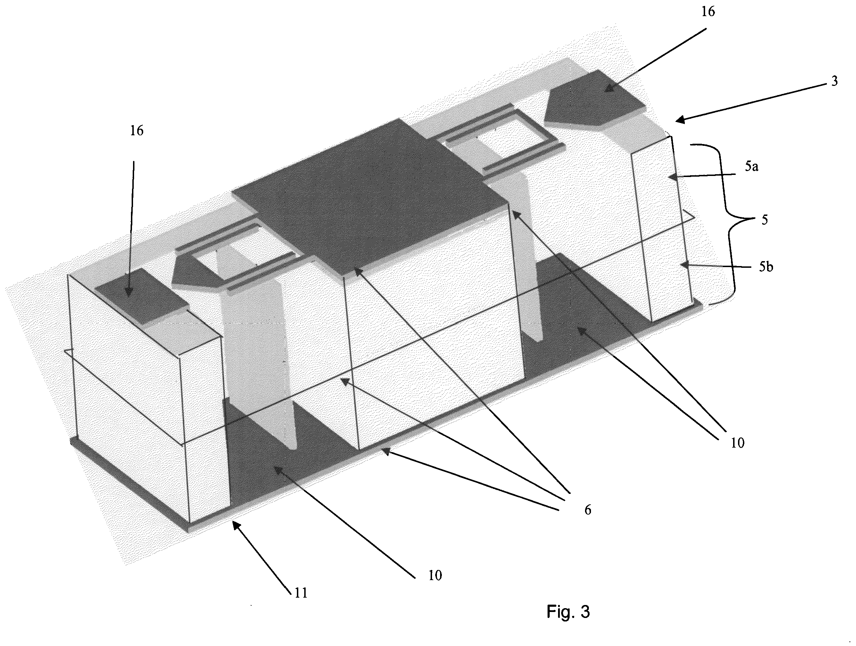

An exemplary embodiment of a photovoltaic element including a 2D-3D resonator **4** and arranged on a semiconductor structure **5** is described in Fig. 3. This embodiment of the 2D-3D resonator **4** is arranged on a semiconductor structure **5.** This structure consists of two parts, namely region **5a** without electromagnetic damping and region **5b** with electromagnetic damping; the parts are bounded by virtual boundaries **6** of variation in material properties. Mutual arrangement (configuration) of individual parts of the photovoltaic element is shown in Fig. 4. The 2D-3D resonator **4** consists of a transformation component **8** (which is composed of a pair of electrodes in the form of coupled conductors), a reflector **7**, and a dielectric **10**. The 2D-3D resonator **4** is further embedded in the semiconductor structure **5;** the geometry is designed in dependence on the wavelength of the impinging electromagnetic wave, namely in such a manner that the thickness of the semiconductor structure **5** will be minimally ¼ of the wavelength of the lowest frequency of the incident electromagnetic radiation. The proposed geometry design will ensure the resulting resonance characteristic according to Fig. 10.

After impinging on the incidence plane **3**, the electromagnetic wave permeates through the semiconductor structure **5.** On the surface of the semiconductor structure **5** at the location of the incidence plane **3,** the 2D part of the resonator **4** is modified, whereas the 3D part interferes with the semiconductor structure **5** (as illustrated in Figs. 3 or 4). The semiconductor structure **5** is instrumental towards setting the conditions of the electrical and magnetic components maxima in the electromagnetic wave incidence plane **3.** In this respect, the semiconductor structure **5** is formed by the region **5a** without electromagnetic damping, whose function is to allow the advancing electromagnetic wave on the semiconductor structure **5** to link and create a resonant region with a maximum resonance in the incidence plane **3.** The region **5b** with electromagnetic damping is instrumental towards slow damping of the advancing electromagnetic wave, which progresses in the direction from the incidence plane **3** to internal structures of the semiconductor structure **5** and causes a condition in which there occurs minimum reflection of the progressive wave from the electrode **11** back to the semiconductor structures **5b** and **5a.** The main function of the region **5b** with electromagnetic damping is to prevent the electromagnetic wave at the end of the semiconductor structure **5** from bouncing back and allowing the generation of a stationary electromagnetic wave. The dimensions of the region **5a** without electromagnetic damping as well as the region **5b** with electromagnetic damping are selected to be, at the minimum, equal to or greater than one quarter of the wavelength of the impinging electromagnetic wave **1** (for example, both layers may show the thickness of 10 µm).

Through the achievement of a resonant state, there occurs in one photovoltaic element a multiple increase of amplitudes of the original impinging electromagnetic wave, and for the assumed wavelength of the electromagnetic wave **1** impinging on the incidence plane **3** of the semiconductor structure **5** we can obtain an electric voltage applicable for further processing by electronic circuits **12** that manage the performance and mode of the periodic structure designed for energy harvesting.

A high-quality conductor is applied as the material of conductive paths formed in the incidence plane **3,** on which the 2D part of resonator **4** is arranged; the same high-quality conductor is also used for the connecting conductive element **9** and the material of the nonlinear element **15.** The region **5a** without electromagnetic damping is formed by a combination of the dielectric **10** and a conductive and/or semi-conductive material. The region **5b** with electromagnetic damping is formed by a material changing the specific conductance, which increases in the direction from the electromagnetic wave **1** incidence plane **3.**

The designed semiconductor structure **5** of the photovoltaic element operates in the resonant state, which enables us to advantageously obtain on the resonator **4** multiple (2-1000) values of amplitude of the electric component of the impinging electromagnetic wave **1.** The proposed periodic arrangement allows operation in the resonant mode for frequencies *f* with a change of frequency *Δf*. It is possible to achieve parameter *Δf*/*f* at the interval of 0.5 to 1.5.

The classical solution using antennas and standard resonant circuits usually makes it possible to achieve only the rate of Δ*f*/*f* at the interval of 0.9 to 1.1. The solution proposed in this document, thanks to the absorption characteristics of the region **5b** with electromagnetic damping and the dimensions with respect to the wavelength, allows the achievement of the above-noted rate of Δ*f*/*f*. This condition can be advantageously utilized for the design of an optimal semiconductor structure **5** and for approaching the ideal state of 100% harvest rate as related to the transformation of the electromagnetic wave **1** impinging on the elements on the generator voltage.

A necessary prerequisite for the utilization of the basic element (at the very minimum) as an electric energy source consists in connecting the electronic external circuit **12,** which allows that, at any loading (load impedance *Z* **13** assumes the values from the interval 0 to ∞ Ohms) of the output of the circuit **12,** the variation of electrical load *Z*i on the input of the circuit **12** will not manifest itself. Thus, the basic component or group of components will remain in the resonant state.

### Industrial Applicability

The described photovoltaic element can be utilized as a harvester or generator of electric energy, possibly also as a sensor or nonlinear converter.

### SUMMARY OF APPLIED REFERENTIAL SYMBOLS

1. electromagnetic wave
2. wave impingement location
3. area-plane of incidence
4. basic resonator
5. semiconductor structure
5a. region without electromagnetic damping
5b. region with electromagnetic damping
6. boundary of variation in material properties
7. basic resonator reflector
8. transformation component
9. connecting component of basic resonators
10. dielectric
11. reference electrode
12. electric circuit
13. load
14. inductor
15. nonlinear component
16. connecting component
17. second capacitor
18. first capacitor
19. source of current or voltage caused by induction from an electromagnetic wave

## Claims

1. A photovoltaic element including at least one 2D-3D resonator (4) and a reference electrode (11), wherein said 2D-3D resonator (4) is arranged on a semiconductor structure (5) and is formed by two parts, of which the first part is a 2D part constituted by a transformation element (8) arranged on an incidence plane (3) and consisting of a pair of electrodes in the form of coupled conductors and the second part is a 3D part arranged inside the semiconductor structure (5) and comprises a dielectric (10), wherein the transformation element (8) of the 2D part is arranged on the dielectric (10) of the 3D part, **characterised in that** the semiconductor structure (5) is formed by a region without electromagnetic damping (5a), whose upper plane constitutes the incidence plane (3), and a region with electromagnetic damping (5b), the region without electromagnetic damping (5a) and the region with electromagnetic damping (5b) being bounded by virtual boundaries (6) of variations in material properties and being distinguished by that the region with electromagnetic damping (5b), in contrast to the region without electromagnetic damping (5a), shows increasing gamma conductivity in S/m in the direction of the reference electrode (11), wherein the 3D part of the 2D-3D resonator (4) is constituted by the dielectric (10) and a reflector (7) matched with and surrounded by the dielectric (10), wherein the dielectric (10) and the reflector (7) are arranged both inside the region without electromagnetic damping (5a) and inside the region with electromagnetic damping (5b) of the semiconductor structure (5), and the reference electrode (11) borders on the region with electromagnetic damping (5b) and is located underneath the region with electromagnetic damping (5b), the dielectric (10) and the reflector (7).

2. The photovoltaic element including a resonator according to claim 1, **characterised in that** the reflector (7) is arranged orthogonally to the incidence plane (3).

## Patentansprüche

1. Ein fotovoltaisches Element mit mindestens einem 2D-3D-Resonator (4) und einer Referenzelektrode (11), wobei der 2D-3D-Resonator (4) auf einer Halbleiterstruktur (5) angeordnet und durch zwei Teile gebildet ist, von denen der erste Teil ein durch ein Transformationselement (8) gebildetes 2D-Teil ist, die auf einer Einfallsebene (3) angeordnet sind und aus einem Paar von Elektroden in Form von gekoppelten Leitern besteht, und der zweite Teil ein innerhalb der Halbleiterstruktur (5) angeordnetes 3D-Teil ist und ein Dielektrikum (10) aufweist, wobei das Transformationselement (8) des 2D-Teils auf dem Dielektrikum (10) des 3D-Teils angeordnet ist, **dadurch gekennzeichnet, dass** die Halbleiterstruktur (5) durch einen Bereich (5a) ohne elektromagnetische Dämpfung, dessen obere Ebene die Einfallsebene (3) bildet, und durch einen Bereich (5b) mit elektromagnetischer Dämpfung gebildet ist, wobei der Bereich (5a) ohne elektromagnetische Dämpfung und der Bereich (5b) mit elektromagnetischer Dämpfung durch virtuelle Grenzen (6) von Materialeigenschaftsschwankungen begrenzt sind, und sich dadurch auszeichnen, dass der Bereich (5b) mit elektromagnetischer Dämpfung im Gegensatz zum Bereich (5a) ohne elektromagnetische Dämpfung, eine Erhöhung der Gamma-Leitfähigkeit in S/m in Richtung der Referenzelektrode (11) anzeigt, wobei der 3D-Teil des 2D-3D-Resonators (4) durch das Dielektrikum (10) und einen dem Dielektrikum (10) zugeordneten und von dem Dielektrikum (10) umgebenen Reflektor (7) gebildet ist, wobei das Dielektrikum (10) und der Reflektor (7) sowohl innerhalb des Bereichs (5a) ohne elektromagnetische Dämpfung als auch innerhalb des Bereichs (5b) mit elektromagnetischer Dämpfung der Halbleiterstruktur (5) angeordnet sind, und die Referenzelektrode (11) an den Bereich (5b) mit elektromagnetischer Dämpfung angrenzt und sich unterhalb des Bereichs (5b) mit elektromagnetischer Dämpfung, des Dielektrikums (10) und des Reflektors (7) befindet.

2. Das fotovoltaische Element mit einem Resonator nach Anspruch 1, **dadurch gekennzeichnet, dass** der Reflektor (7) orthogonal zur Einfallsebene (3) angeordnet ist.

## Revendications

1. Un élément photovoltaïque comprenant au moins un résonateur 2D-3D (4) et une électrode de référence (11), où le résonateur 2D-3D (4) est disposé sur une structure semi-conductrice (5) et est formé de deux parties, dont la première partie est une partie 2D constituée par un élément de transformation (8) disposé sur un plan d'incidence (3) et constitué d'une paire d'électrodes sous la forme de conducteurs couplés, et la seconde partie est une partie 3D disposée à l'intérieur de la structure semi-conductrice (5) et comprend un diélectrique (10), où l'élément de transformation (8) de la partie 2D est disposé sur le diélectrique (10) de la partie 3D, **caractérisé en ce que** la structure semi-conductrice (5) est formée par une région sans amortissement électromagnétique (5a), dont le plan supérieur constitue le plan d'incidence (3), et par une région à amortissement électromagnétique (5b), où la région sans amortissement électromagnétique (5a) et la région à amortissement électromagnétique (5b) sont délimitées par des limites virtuelles (6) de variations de propriétés de matériau et sont **caractérisées en ce que** la région à amortissement électromagnétique (5b), contrairement à la région sans amortissement électromagnétique (5a), présente une conductivité gamma croissante dans S/m dans la direction de l'électrode de référence (11), où la partie 3D du résonateur 2D-3D (4) est constituée par le diélectrique (10) et un réflecteur (7) adapté à et entouré par le diélectrique (10), où le diélectrique (10) et le réflecteur (7) sont disposés à la fois à l'intérieur de la région sans amortissement électromagnétique (5a) et à l'intérieur de la région à amortissement électromagnétique (5b) de la structure semi-conductrice (5), et l'électrode de référence (11) est adjacente à la région à amortissement électromagnétique (5b) et est située sous la région à amortissement électromagnétique (5b), le diélectrique (10) et le réflecteur (7).

2. L'élément photovoltaïque comprenant un résonateur selon la revendication 1, **caractérisé en ce que** le réflecteur (7) est disposé orthogonalement au plan d'incidence (3).
